# EUROPÄISCHE PATENTSCHRIFT

(11) **EP 2 564 277 B1**
(45) Veröffentlichungstag und Bekanntmachung des Hinweises auf die Patenterteilung: **03.10.2018**
(21) Anmeldenummer: 11717558.8
(22) Anmeldetag: 26.04.2011
(51) Int. Cl.: G05B 19/042, G05B 23/02, G01R 31/00

(54) **VERFAHREN UND VORRICHTUNG ZUM IDENTIFIZIEREN EINER ZUORDNUNG VON REGELKREISEN ZU MINDESTENS EINER REGELVORRICHTUNG**
METHOD AND APPARATUS FOR IDENTIFYING AN ASSOCIATION OF CONTROL LOOPS WITH AT LEAST ONE CONTROL DEVICE
PROCÉDÉ ET DISPOSITIF POUR IDENTIFIER UNE AFFECTATION DE CIRCUITS DE RÉGLAGE À AU MOINS UN DISPOSITIF DE RÉGLAGE

(30) Priorität: 27.04.2010 US 328304 P; 27.04.2010 DE 102010028263
(43) Veröffentlichungstag der Anmeldung: 06.03.2013
(73) Patentinhaber: Airbus Operations GmbH, 21129 Hamburg (DE)
(72) Erfinder: ROEDERER, Karsten, 21031 Hamburg (DE); JALASS, Maik, 21259 Otter (DE)
(74) Vertreter: Isarpatent
(86) Internationale Anmeldenummer: PCT/EP2011/056518
(87) Internationale Veröffentlichungsnummer: WO 2011/134926

(56) Entgegenhaltungen:
- EP-A1- 0 088 163
- EP-A1- 1 226 989
- DE-A1- 10 242 007
- DE-A1-102008 005 700

## Beschreibung

Die vorliegende Erfindung betrifft ein Verfahren zum Erkennen von Verkabelungen von einer Vielzahl von Geräten zu mindestens einem weiteren Gerät und insbesondere ein Verfahren zum Identifizieren einer Zuordnung von Regelkreisen zu mindestens einer Regelvorrichtung. Die Erfindung betrifft ferner eine entsprechende Vorrichtung zum Identifizieren einer Zuordnung von Regelkreisen zu mindestens einer Regelvorrichtung sowie ein Computerprogrammprodukt mit Programmbefehlen zur Durchführung des Verfahrens und einen Datenspeicher zum Abspeichern des Computerprogrammprodukts.

In komplexen Geräten und Maschinen sind typischerweise eine Vielzahl von Geräten verbaut, welche mittels einer zentralen Steuereinheit angesteuert werden. Hierbei kann die Vielzahl an Geräten mittels Kabelverbindungen an der zentralen Steuereinheit angeschlossen sein. Eine Kabelverbindung wird zum Beispiel zwischen jedem einzelnen verbauten Gerät und einer speziell dafür vorgesehenen Schnittstelle in der zentralen Steuereinheit hergestellt. Um eine korrekte Datenübertragung zwischen der Vielzahl an Geräten und der zentralen Steuervorrichtung zu gewährleisten sind die Schnittstellen der zentralen Steuervorrichtung typischerweise an die jeweils angeschlossenen Geräte angepasst. Somit kann es notwendig sein, dass jedes einzelne Gerät genau an der dafür vorgesehenen Schnittstelle der zentralen Steuervorrichtung angeschlossen ist. Hierbei ist es jedoch möglich, dass insbesondere bei einer großen Anzahl von anzuschließenden Geräten eine ungewollte Vertauschung bei der Verkabelung erfolgt. In diesem Falle kommuniziert nicht jedes der angeschlossenen Geräte mittels der dafür vorgesehenen Schnittstelle mit der zentrale Steuervorrichtung. Daraus kann eine fehlerhafte Datenübertragung beziehungsweise ein Ansteuern von ungeeigneten Geräten resultieren. Ein Überprüfen einer bestehenden Verkabelung auf deren Richtigkeit, das heißt ob jedes Gerät mit der dafür vorgesehenen Schnittstelle verbunden ist, ist zeitaufwändig. Zudem variiert in Abhängigkeit der jeweiligen Positionen bzw. Lage der Verkabelung innerhalb der Maschine der Arbeitsaufwand bei einer Überprüfung. Ferner kann es bei geschlossenen Kabelschächten nahezu unmöglich sein, eine bereits bestehende Verkabelung auf deren Richtigkeit hin zu prüfen.

Herkömmliche Verfahren zum Überprüfen von Kabelverbindungen finden beispielsweise bei einem Überprüfen von Heizungssystemen in Flugzeugen Einsatz. Die DE 10 2008 005 700 A1 beschreibt ein System zum Verhindern von Vereisungen in einer Rohrleitung, wie sie beispielsweise in einer Rohrleitung eines Flugzeugwassersystems auftreten kann. Hierbei sind innerhalb eines Flugzeugs Heizkreise vorgesehen, welche ein Vereisen von Bordteilen des Flugzeugs verhindern. Ein solcher Heizkreis kann mehrere Controller bzw. Steuereinheiten, zum Beispiel eine IPCU, auch als Ice Protection Control Unit bekannt, umfassen, welche wiederum eine Mehrzahl an Heizeinheiten und entsprechenden Wärmefühlern aufweisen. Die an die Controller angeschlossenen Heizelemente und Sensoren können in dem gesamten Flugzeug verteilt sein und zum Beispiel ein Funktionieren eines Wassersystems des Flugzeuges in kalten Umgebungsbedingungen gewährleisten. Bei einer fehlerhaften Verkabelung ist die einwandfreie Funktion dieses Heizungssystems gemäß herkömmlicher Verfahren nicht zu gewährleisten.

Gemäß weiterer, herkömmlicher Verfahren werden manuelle Tests ausgeführt, bei der jede Heizungseinrichtung einzeln in Betrieb genommen wird und nach einer Aufheizphase ein Auslesen der angeschlossenen Sensorik durchgeführt wird. Eine Temperaturerhöhung an einem Heizelement wird durch Widerstandsänderungen an dem entsprechenden Sensor abgelesen. Die Temperaturänderung an dem Heizelement und somit die Erkennung am Temperatursensor benötigt eine bestimmte Wartezeit, zum Beispiel 5 Minuten je Testzyklus. Durch die aufeinanderfolgende Abarbeitung der einzelnen Heizkreise ist der zeitliche Aufwand hierbei hoch, das heißt, der Zeitaufwand steigt linear mit der Anzahl der zu prüfenden Regelkreise an.

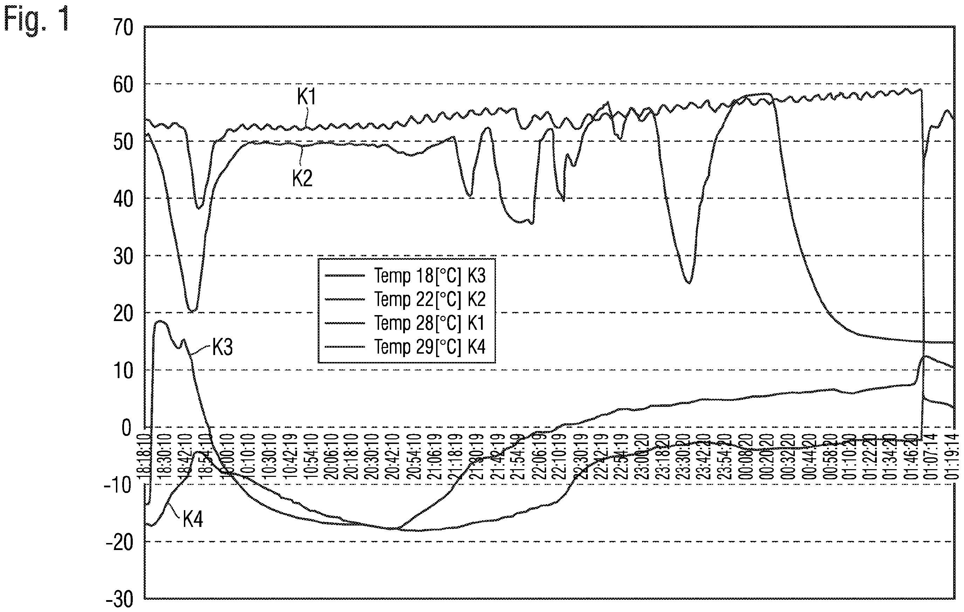

Figur 1 zeigt zur Verdeutlichung des der vorliegenden Erfindung zugrundeliegenden Problems ein Diagramm mit Messdaten eines fehlerhaft verkabelten Heizungssystems. Hierbei sind in dem in der Figur 1 gezeigten Diagramm an der X-Achse Zeitangaben angetragen und an der Y-Achse sind Temperaturangaben angetragen. Bei den Zeitangaben entlang der X-Achse des vorliegenden Diagramms handelt es sich um Messzeitpunkte, an denen Wärmemessungen an Heizelementen eines Flugzeugs durchgeführt werden. Bei den Temperaturangaben entlang der Y-Achse handelt es sich um die jeweilige Temperatur der Heizelemente zu dem jeweils entlang der X-Achse angeordneten Messpunkt.

Das den Messdaten des vorliegenden Diagramms zugrundeliegende, simulierte Heizsystem ist zum Verhindern eines Temperaturabfalls bei Elementen des Flugzeugs vorgesehen. Der erzielende Temperaturbereich des jeweiligen Heizelements liegt vorzugsweise zwischen 6°C und 10°C. Da es jedoch in dem gezeigten Beispiel bei dem zugrundeliegenden Heizungssystem in der Versuchsanordnung zu einer Vertauschung bei der Verkabelung zwischen einem Steuerelement und dem jeweiligen Heizelement gekommen ist, wird der angestrebte Temperaturbereich der Heizelemente nicht erreicht. Demgemäß werden die Heizelemente, welche den Temperaturkurven K1 und K2 zugrundeliegen, zu oft angesteuert bzw. aktiviert, wohingegen diejenigen Heizelemente, welche den Temperaturkurven K3 und K4 zugrunde liegen, zu selten angesprochen bzw. aktiviert werden. Somit kann es zu einem Temperaturanstieg bei einzelnen Bauelementen in der Versuchsanordnung kommen, wie dies die Temperaturkurven K1 und K2 anzeigen. Ferner kann es in Folge des Verlaufs der Temperaturkurven K3 und K4 zu einem Temperaturabfall bei von Bauelementen des Flugzeuges in der Versuchsanordnung kommen. Um die Vertauschung der Verkabelung zu identifizieren ist gemäß herkömmlicher Verfahren ein hoher Testaufwand notwendig.

Die EP 1 226 989 A1 zeigt ein Verfahren zum Identifizieren von Aktuatoren in einem Fahrzeug.

Demgemäß ist es eine Aufgabe der vorliegenden Erfindung, ein Verfahren und eine Vorrichtung bereitzustellen, welche es erlauben, eine Zuordnung einer Mehrzahl von Geräten zu mindestens einem weiteren Gerät bezüglich ihrer korrekten Verkabelung, insbesondere bezüglich eines Vorhandenseins einer vorgesehenen Verkabelung, bereitzustellen.

Diese Aufgabe wird durch ein Verfahren zum Identifizieren einer Zuordnung von Regelkreisen zu mindestens einer Regelvorrichtung gemäß Patentanspruch 1 gelöst.

Eine Zuordnung von Regelkreisen zu mindestens einer Regelvorrichtung kann mittels einer gespeicherten Tabelle durchgeführt werden, welche einer bestimmten Anzahl an Regelvorrichtungen jeweils eine Anzahl an Regelkreisen zuweist. Demgemäß können Regelkreise auch mittels einer kabellosen Schnittstelle von der Regelvorrichtung angesteuert werden. Ferner ist es möglich, dass in der Regelvorrichtung Schnittstellen vorgesehen sind, welche der Kommunikation mit den einzelnen Regelkreisen dienen.

Ein Regelkreis kann einen beliebigen Aktuator und einen beliebigen Sensor umfassen. Ein Aktuator kann hierbei z. B. als ein Heizelement vorliegen. Ein Sensor kann z. B. durch einen Wärmefühler gebildet werden. Der Sensor ist geeignet, mindestens eine Aktion beziehungsweise mindestens einen Zustand eines zugehörigen Aktuators zu überwachen. Weitere Beispiele für eine konkrete Ausgestaltung eines Aktuators beziehungsweise eines Sensors sind eine Lichtquelle mitsamt eines Helligkeitssensors, ein Motor mitsamt eines Drehzahlmessers oder eine Pumpe mitsamt des Druckmessers. Dem Durchschnittsfachmann ist hierbei eine Vielzahl an weiteren Möglichkeiten der konkreten Ausgestaltung eines Aktuators beziehungsweise Sensors bekannt.

Die Regelvorrichtung ist geeignet mindestens einen Regelkreis anzusteuern. Die Regelvorrichtung kann z. B. geeignet sein, ein Beheizen eines Heizelementes zu veranlassen. Die daraus resultierende Zustandsänderung des Heizelementes, nämlich eine Temperaturerhöhung, kann nunmehr mittels eines entsprechenden Temperaturfühlers ermittelt werden. Die Regelvorrichtung kann auch als zentrale Steuereinheit bezeichnet werden, welche zumindest eine Auswahl an Regelkreisen ansteuert. Die Regelvorrichtung kann geeignet sein, einen Sensor des Regelkreises auszulesen und in Abhängigkeit des ausgelesenen Sensorwertes den zugehörigen Aktuator anzusteuern.

Ein Ansteuern von mindestens einem Regelkreis erfolgt in Abhängigkeit mindestens eines Ansteuerungsmusters. Ein Ansteuerungsmuster umfasst hierbei einen Hinweis auf Regelkreise, welche angesteuert werden sollen. Das Ansteuerungsmuster kann zum Beispiel einzelne Regelkreise benennen, welche gemäß einer vorbestimmten Aktion angesteuert werden sollen. Das Ansteuerungsmuster kann mittels eines Identifikators einzelne Regelkreise spezifizieren und hierbei angeben, in welcher Weise eben diese Regelkreise angesprochen werden sollen. Weist der Regelkreis ein Heizelement auf, so kann in dem Ansteuerungsmuster spezifiziert werden, dass dieses Heizelement zu einer bestimmten Zeit, zum Beispiel während eines Zeitintervalls, erhitzt werden soll. Hierbei definiert das Ansteuerungsmuster z. B. eine elektrische Spannung, welche zum Erhitzen des Heizelementes an diesem angelegt wird. Es ist von Vorteil, ein Zeitintervall z. B. für eine Heizphase in Minuten zu spezifizieren, welches die benötigte Zeit angibt, um das entsprechende Heizelement aufzuwärmen. Ferner ist es möglich, einen Temperaturschwellwert zu definieren, bei dessen Überschreiten das Heizelement nicht mehr angesteuert wird bzw. aktiviert wird.

Zum eindeutigen Ansteuern des einzelnen Regelkreises wird jedem Regelkreis ein Identifikator, zum Beispiel in Abhängigkeit einer Seriennummer, zugewiesen. Ferner ist es möglich, die einzelnen Regelkreise mittels der dafür vorgesehenen Schnittstelle anzusteuern. Dabei wird nicht direkt der einzelne Regelkreis angesteuert, sondern es wird die für den jeweiligen Regelkreis vorgesehene Schnittstelle angesteuert.

Das Bereitstellen des Ansteuerungsmusters wird vorzugsweise durch Auslesen eines Datenspeichers durchgeführt. Somit kann ein Ansteuerungsmuster bezüglich einer auszuliefernden Maschine von dem Hersteller der Maschine auf einem Datenspeicher innerhalb der Maschine abgelegt werden. Ferner ist es möglich, das Ansteuerungsmuster dynamisch in Abhängigkeit der Anzahl der Regelkreise sowie der Anzahl der Regelvorrichtungen zu definieren. Hierbei wird ein einzelnes Ansteuerungsmuster bereitgestellt, indem aus einer Vielzahl von Ansteuerungsmustern eines in Abhängigkeit der Anzahl der Regelkreise ausgewählt wird. Hierzu kann eine gespeicherte Tabelle bereitgestellt werden, welche definiert, welches Ansteuerungsmuster ausgewählt werden soll, falls eine gewisse Anzahl an Regelkreisen sowie eine gewisse Anzahl an Regelvorrichtungen vorliegt. Weiterhin kann das Ansteuerungsmuster mittels mindestens eines Berechnungsschrittes berechnet werden. Hierzu eignen sich Algorithmen, welche alle Möglichkeiten, das heißt alle möglichen Permutationen von Regelkreisen und Regelvorrichtungen, erzeugen und somit jeweils ein eindeutiges Muster zur Identifikation des jeweiligen Regelkreises erzeugen. Hierbei ist es möglich, mittels des Algorithmus einen Binärcode zu bestimmen, welcher sich zum eindeutigen Ansteuern jedes einzelnen Regelkreises eignet. Hierbei ist es vorteilhaft, dass bezüglich jedes einzelnen Regelkreises ein unterschiedlicher Binärcode errechnet wird, mittels dem sich eben dieser Regelkreis eindeutig ansprechen lässt. Somit kann ein Ansteuerungsmuster einen Binärcode für jeden Regelkreis umfassen. Zusätzlich kann in dem Ansteuerungsmuster spezifiziert sein, ob der jeweilige Regelkreis der Binärcodes angesteuert werden soll oder nicht. Dies kann mittels eines Setzens eines Ansteuerungsbits durchgeführt werden.

Nach einem Bereitstellen eines Ansteuerungsmusters erfolgt ein Ansteuern der Regelkreise gemäß diesem bereitgestellten Ansteuerungsmuster. Hierbei kann das bereitgestellte Ansteuerungsmuster ausgelesen werden und es können genau die Regelkreise angesprochen werden, welche in dem bereitgestellten Ansteuerungsmuster identifiziert sind. Dies wird als ein Anwenden des Ansteuerungsmusters auf die einzelnen Regelkreise bezeichnet. Werden die einzelnen Regelkreise gemäß dem bereitgestellten Ansteuerungsmuster angesprochen, so führen die einzelnen Regelkreise beziehungsweise die Aktuatoren der jeweiligen Regelkreise, die in dem Ansteuerungsmuster vorbestimmte Aktion aus. Gibt das Ansteuerungsmuster beispielsweise an, dass alle Heizelemente mit geradem Binärcode angesprochen werden sollen, so ist bei einer korrektren Verkabelung zu erwarten, dass eine Temperaturerhöhung bei Heizelementen mit geradem Binärcode zu messen ist. Das Ausmessen der Zustandsänderung der jeweiligen Aktuatoren wird in einem weiteren Ansteuerungsmuster abgespeichert. Somit erfolgt ein Messen eines weiteren Ansteuerungsmusters, welches als das tatsächliche Ansteuerungsmuster bezeichnet wird. Bei einer korrekten Verkabelung ist zu erwarten, dass das bereitgestellte erste Ansteuerungsmuster mit dem gemessenen zweiten Ansteuerungsmuster übereinstimmt. Stimmen das erste bereitgestellte Ansteuerungsmuster und das zweite gemessene Ansteuerungsmuster nicht überein, so ist es möglich, dass aufgrund einer falschen Verkabelung falsche Aktuatoren angesprochen werden.

Aus dem bereitgestellten ersten Ansteuerungsmuster und dem gemessenen zweiten Ansteuerungsmuster kann nunmehr die Zuordnung von Regelkreisen zu mindestens einer Regelvorrichtung ausgelesen werden. Dies erfolgt zum Beispiel mittels eines Vergleichens des bereitgestellten Ansteuerungsmuster mit dem gemessenen Ansteuerungsmuster.

Das vorgeschlagene Verfahren kann zum Beispiel vor einer Auslieferung eines Flugzeuges Anwendung finden, wodurch eine falsche Verkabelung innerhalb des Flugzeuges mit geringem Testaufwand frühzeitig erkannt wird.

In einer Ausführungsform des Verfahrens zum Identifizieren einer Zuordnung von Regelkreisen weist das bereitgestellte Ansteuerungsmuster und/oder das gemessene Ansteuerungsmuster Ansteuerungsphasen auf.

Dies hat den Vorteil, dass die Ansteuerungsmuster in einzelnen Phasen unterteilt sind, gemäß denen die Regelkreise, zum Beispiel alternierend angesprochen werden können. Somit ist es möglich, alle Permutationen der Zuordnung von Regelkreisen zu Regelvorrichtungen abzuprüfen und entsprechend zu analysieren.

In einer weiteren Ausführungsform des Verfahrens zum Identifizieren einer Zuordnung von Regelkreisen beschreiben die Ansteuerungsphasen eine Auswahl an anzusteuernden Regelkreisen.

Dies hat den Vorteil, dass jeweils eine Auswahl an anzusteuernden Regelkreisen angesprochen werden kann und somit in jeder Phase eine Mehrzahl an Regelkreisen geprüft werden kann.

In einer weiteren Ausführungsform des Verfahrens zum Identifizieren einer Zuordnung von Regelkreisen erfolgt das Ansteuern der Regelkreise mittels eines Ausführens der Ansteuerungsphasen.

Dies hat den Vorteil, dass die Ansteuerungsphasen sukzessive abgearbeitet werden können oder auch in bestimmten Reihenfolgen, welche zum Beispiel in einem Ansteuerungsmuster definiert sind, abgearbeitet werden können.

In einer weiteren Ausführungsform des Verfahrens zum Identifizieren einer Zuordnung von Regelkreisen werden das bereitgestellte Ansteuerungsmuster und/oder das gemessene Ansteuerungsmuster mittels mindestens eines Binärcodes dargestellt.

Dies hat den Vorteil, dass die Ansteuerungsmuster effizient abgespeichert und/oder verarbeitet werden können, falls das Ansteuern der einzelnen Regelkreise gemäß einer binären Aktion durchgeführt wird. Hierbei ist es auch möglich, dass andere Codes, welche zum Beispiel auf einem anderen Zahlensystem basieren Anwendung finden.

In einer weiteren Ausführungsform des Verfahrens zum Identifizieren einer Zuordnung von Regelkreisen ist die Anzahl der Stellen mindestens eines Binärcodes gleich der Anzahl der Ansteuerungsphasen.

Dies hat den Vorteil, dass die Ansteuerungsphasen bitweise abgearbeitet werden können. Das heißt, dass während jeder Ansteuerungsphase an einer vordefinierten Stelle des Binärcodes geprüft wird, ob das entsprechende Bit an dieser Stelle gesetzt ist oder nicht, und in Abhängigkeit dieses Bits ein Ansteuern des jeweiligen Regelkreises durchgeführt wird.

In einer weiteren Ausführungsform des Verfahrens zum Identifizieren einer Zuordnung von Regelkreisen liegt das bereitgestellte Ansteuerungsmuster und/oder das gemessene Ansteuerungsmuster als mindestens eine gespeicherte Tabelle vor.

Dies hat den Vorteil, dass das Ansteuerungsmuster in übersichtlicher Weise und gemäß bereits bestehender Datenmodelle vorliegen kann.

In einer weiteren Ausführungsform des Verfahrens zum Identifizieren einer Zuordnung von Regelkreisen beschreiben Spalten der Tabelle die Ansteuerungsphasen und Zeilen der Tabelle beschreiben die Binärcodes.

Dies hat den Vorteil, dass die Ansteuerungsmuster in intuitiv verständlicher Form vorliegen und, dass der Binärcode des jeweiligen Regelkreises zeilenweise aus der gespeicherten Tabelle ausgelesen werden kann.

In einer weiteren Ausführungsform des Verfahrens zum Identifizieren einer Zuordnung von Regelkreisen liegt die Regelvorrichtung als mindestens eine Steuervorrichtung, eine Kontrollvorrichtung, eine Messvorrichtung und/oder eine Auswertevorrichtung vor.

Dies hat den Vorteil, dass die Regelvorrichtung als eine Vielzahl von bereits vorhandenen Vorrichtungen beziehungsweise Einheiten vorliegen kann.

In einer weiteren Ausführungsform des Verfahrens zum Identifizieren einer Zuordnung von Regelkreisen weisen die Regelkreise jeweils mindestens einen Sensor und mindestens einen anzusteuernden Aktor auf.

Dies hat den Vorteil, dass ein Regelkreis eine vorbestimmte Aktion ausführen kann und dass diese Aktion, zum Beispiel in Form einer Zustandsänderung, gemessen werden kann.

In einer weiteren Ausführungsform des Verfahrens zum Identifizieren einer Zuordnung von Regelkreisen liegen die Regelkreise als Heizkreise vor.

Dies hat den Vorteil, dass die vorliegende Erfindung insbesondere im Fahrzeugbau beziehungsweise im Flugzeugbau Anwendung finden kann.

Die Aufgabe wird ferner gelöst durch eine Vorrichtung zur Identifikation einer Zuordnung von Regelkreisen zu mindestens einer Regelvorrichtung mit den Merkmalen des Patentanspruchs 7.

Ferner ist ein Computerprogrammprodukt mit den Merkmalen des Patentanspruchs 10 und ein Datenspeicher mit den Merkmalen des Patentanspruchs 11 vorgesehen.

Weitere vorteilhafte Ausgestaltungen der Erfindung sind Gegenstand der Unteransprüche sowie der im Folgenden beschriebenen Ausführungsbeispiele. Im Weiteren wird die Erfindung anhand beispielhafter Implementierungen unter Bezugnahme auf die beigelegten Figuren näher erläutert.

Es zeigen:
- Figur 1: ein Signaldiagramm zur Darstellung der der Erfindung zugrundeliegenden Problematik, wie bereits in der Beschreibungseinleitung beschrieben;
- Figur 2: ein Ablaufdiagramm eines Verfahrens zum Identifizieren einer Zuordnung von Regelkreisen zu mindestens einer Regelvorrichtung gemäß einer Ausführungsform der vorliegenden Erfindung;
- Figur 3: ein detailliertes Ablaufdiagramm eines Verfahrens zum Identifizieren einer Zuordnung von Regelkreisen zu mindestens einer Regelvorrichtung gemäß einer Ausführungsform der vorliegenden Erfindung;
- Figur 4: eine schematische Darstellung eines Ansteuerungsmusters gemäß einer Ausführungsform der vorliegenden Erfindung;
- Figur 5: eine schematische Darstellung einer Regelvorrichtung gemäß einem Ausführungsbeispiel der vorliegenden Erfindung;
- Figur 6: eine schematische Darstellung eines bereitgestellten Ansteuerungsmusters und eines gemessenen Ansteuerungsmusters gemäß einer Ausführungsform der vorliegenden Erfindung;
- Figur 7: ein Blockschaltbild einer Vorrichtung zur Identifikation einer Zuordnung von Regelkreisen zu mindestens einer Regelvorrichtung gemäß einer Ausführungsform der vorliegenden Erfindung;
- Figur 8: eine schematische Darstellung einer Mehrzahl von Regelkreisen mitsamt Regelvorrichtungen gemäß einer Ausführungsform der vorliegenden Erfindung; und
- Figur 9: eine schematische Darstellung eines bereitgestellten Ansteuerungsmusters gemäß einer Ausführungsform der vorliegenden Erfindung.

In den Figuren sind gleiche beziehungsweise funktionsgleiche Elemente mit den gleichen Bezugszeichen versehen worden, sofern nichts anderes angegeben ist.

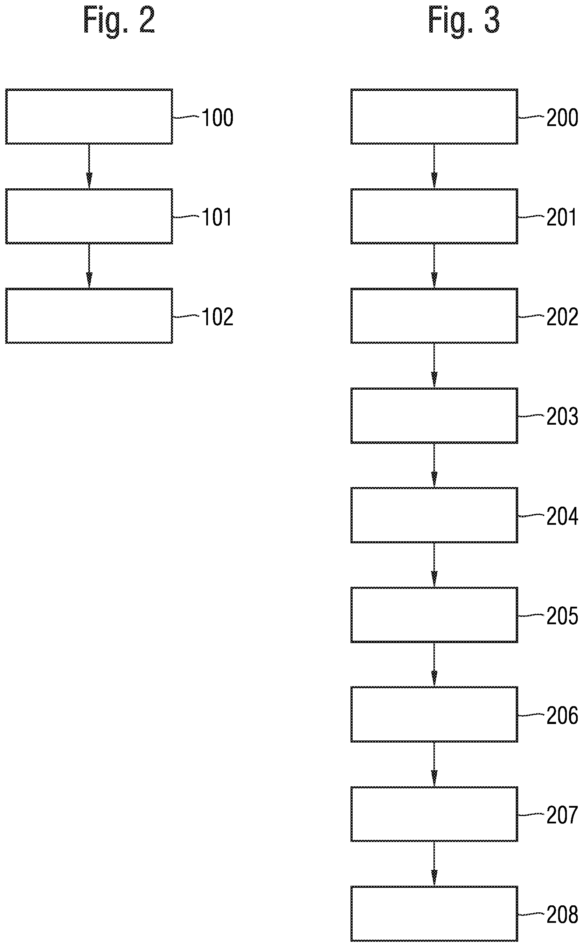

Figur 2 zeigt ein Ablaufdiagramm eines Verfahrens zum Identifizieren einer Zuordnung von Regelkreisen zu mindestens einer Regelvorrichtung und umfasst im Wesentlichen drei Schritte. Zunächst wird in einem Schritt 100 ein Ansteuerungsmuster, welches zum eindeutigen Ansteuern jedes einzelnen Regelkreises durch die Regelvorrichtung geeignet ist, bereitgestellt. Dann folgt in einem Schritt 101 ein Messen eines weiteren Ansteuerungsmusters bei einem Ansteuern der Regelkreise gemäß dem bereitgestellten Ansteuerungsmuster. Schließlich erfolgt im Schritt 102 ein Identifizieren der Zuordnung der Regelkreise zu der mindestens einen Regelvorrichtung mittels eines Vergleichens des bereitgestellten Ansteuerungsmusters und des gemessenen Ansteuerungsmusters.

Die vorbeschriebenen Verfahrensschritte können iterativ und/oder in anderer Reihenfolge ausgeführt werden und können weitere Unterschritte umfassen.

Figur 3 zeigt ein detailliertes Ablaufdiagramm des Verfahrens zum Identifizieren einer Zuordnung von Regelkreisen zu mindestens einer Regelvorrichtung und umfasst die folgenden Schritte.

In zwei vorbereiteten Verfahrensschritten 200 und 201 erfolgt ein Identifizieren von Regelkreisen RK in einem Verfahrensschritt 200 sowie ein Identifizieren von Regelvorrichtungen RV in einem Verfahrensschritt 201. Bei einem Identifizieren von Regelkreisen RK kann es sich um ein Überprüfen eines Vorhandenseins von Regelkreisen RK handeln, welches zum Beispiel mittels eines Überprüfens von Steckverbindungen einer Verkabelung oder des Empfangens eines Statussignals mindestens eines Regelkreises RK durchgeführt wird. Ein Identifizieren von Regelkreisen RK, welche mittels mindestens einer Regelvorrichtung RV angesteuert werden sollen, kann auch mittels eines Auslesens eines Bauplans, insbesondere durch Auslesen eines gespeicherten Bauplans eines Flugzeugs, erfolgen. So ist zum Beispiel bei einem Flugzeugtyp gemäß dessen Bauplan bekannt, welche Regelkreise RK in eben diesem Flugzeug vorhanden sein müssen.

Ferner kann es notwendig sein, zumindest die Anzahl von Regelvorrichtungen RV zu identifizieren. Dies ist insbesondere dann vorteilhaft, wenn eine Mehrzahl an Regelvorrichtungen RV zur Ansteuerung der Regelkreise RK vorgesehen ist. In diesem Falle sind jeweils Regelkreise RK nicht lediglich an einer einzelnen Regelvorrichtung RV angeschlossen, sondern die Regelkreise RK sind an einer Mehrzahl an Regelvorrichtungen RV angeschlossen. Hierbei ist es vorteilhaft, dass ein Regelkreis RK lediglich von einer zugehörigen Regelvorrichtung RV angesteuert wird. Typischerweise sind Regelvorrichtungen RV zum Ansteuern von mehreren Regelkreisen RK geeignet.

In einem darauffolgenden Verfahrensschritt 202 erfolgt ein Bereitstellen zumindest eines Teils eines Ansteuerungsmusters AM. Umfasst das Ansteuerungsmuster AM mehrere Ansteuerungsphasen, so kann in dem Verfahrensschritt 202 eine einzelne Ansteuerungsphase bereitgestellt werden. Es kann jedoch auch eine Auswahl der von dem Ansteuerungsmuster AM umfassten Ansteuerungsphasen bereitgestellt werden. Das Bereitstellen zumindest eines Teils eines Ansteuerungsmusters AM enthält typischerweise weitere Unterschritte, wie zum Beispiel das Berechnen des Ansteuerungsmusters AM. Das Ansteuerungsmuster kann alle Permutationen von An- beziehungsweise Ausschaltzuständen der Regelkreise RK umfassen. Somit ist das Ansteuerungsmuster AM geeignet, alle Kombinationen eines Ansteuerns beziehungsweise Nicht-Ansteuerns von Regelkreisen abzubilden. Hierdurch lässt sich in darauffolgenden Verfahrensschritten eindeutig identifizieren, ob das in dem Verfahrensschritt 202 zumindest teilweise bereitgestellte Ansteuerungsmuster AM tatsächlich mittels der angesteuerten Regelkreise RK umgesetzt wird.

Das Bereitstellen des zumindest einen Teils des Ansteuerungsmusters AM kann mittels eines Auswählens eines Ansteuerungsmusters aus einer Mehrzahl von bereitgestellten Ansteuerungsmustern erfolgen. Hierbei ist es möglich, in vorbereitenden Verfahrensschritten bezüglich eines Flugzeugtyps ein spezifisches Ansteuerungsmuster bereitzustellen. Somit ist es ferner möglich, bezüglich mehrerer Flugzeuge jeweils ein Ansteuerungsmuster AM bereitzustellen und in einem Datenspeicher abzulegen. Ein Ansteuerungsmuster AM wird dann gemäß dem Flugzeugtyp des Flugzeugs ausgewählt, in dem die Regelkreise RK beziehungsweise die Regelvorrichtung RV eingebaut sind. Folglich umfasst der Verfahrensschritt 202 in einer Ausführungsform ein Auslesen eines Ansteuerungsmusters AM aus einem Datenspeicher.

In einem darauffolgenden Verfahrensschritt 203 erfolgt ein Ansteuern mindestens eines Regelkreises RK gemäß des zumindest einen Teils des in Verfahrensschritts 202 bereitgestellten Ansteuerungsmusters AM. Umfasst das Ansteuerungsmusters AM Phasen, so kann in dem Verfahrensschritt 203 ein Ausführen eben dieser Ansteuerungsphase durchgeführt werden. Folglich werden in dem Verfahrensschritt 203 diejenigen Regelkreise RK angesteuert, welche in dem Teil des bereitgestellten Ansteuerungsmusters AM, beziehungsweise der Ansteuerungsphase, spezifiziert sind. Hierbei ist es vorteilhaft in jeder Ansteuerungsphase eine Auswahl beziehungsweise eine Mehrzahl an Regelkreisen RK anzusteuern.

Aus dem Ansteuern der Regelkreise RK in dem Verfahrensschritt 203 erfolgt eine Zustandsänderung desjenigen Regelkreises RK, diesen Zustand in einem darauffolgenden Verfahrensschritt 204 gemessen wird. Zum Beispiel erfolgt in dem Verfahrensschritt 203 ein Ansteuern eines Aktors, welcher in dem Regelkreis RK vorgesehen ist. Ist in dem Regelkreis RK ein weiterer Sensor enthalten, so erfolgt in dem Verfahrensschritt 204 ein Auslesen eben dieses Sensors. Das in dem Verfahrensschritt 204 durchgeführte Messen kann zum Beispiel ein Auslesen eines Temperatursensors, eines Drehzahlmessers, eines Druckmessers und/oder ein Auslesen eines bildgebenden Sensors des Regelkreises RK umfassen.

Nach Ausführung des Verfahrensschrittes 204 kann es vorteilhaft sein, erneut die Verfahrensschritte 202, 203 und 204 durchzuführen. Ist in dem Verfahrensschritt 202 eine Ansteuerungsphase bereitgestellt worden, so kann nach einem Ansteuern der Regelkreise RK gemäß dieser Ausführungsphase und eines Messens der resultierenden Zustandsänderung ein Bereitstellen einer weiteren Ansteuerungsphase im Verfahrensschritt 202 erfolgen. Die gemessenen Zustandsänderungen können in einem Verfahrensschritt 205 abgespeichert werden beziehungsweise zu einem Ausführungsmuster zusammengefügt werden.

Mitunter erfolgt in einem Verfahrensschritt 205 ein Bereitstellen eines gemessenen Ausführungsmusters. Das gemessene Ausführungsmuster gibt hierbei einen Hinweis darauf, welche Regelkreise RK bei einem Ansteuern eines bereitgestellten Ansteuerungsmusters AM tatsächlich angesteuert wurden. Folglich kann man das bereitgestellte Ansteuerungsmuster AM als ein theoretisches Ansteuerungsmuster bzw. Soll-Ansteuerungsmuster bezeichnen und das in dem Verfahrensschritt 205 gemessene Ansteuerungsmuster AM'als das tatsächliche Ansteuerungsmuster bzw. IST-Ansteuerungsmuster bezeichnen.

In einem darauffolgenden Verfahrensschritt 206 erfolgt ein Vergleichen des durch iteriertes Ausführen des Verfahrensschrittes 202 bereitgestellten Ansteuerungsmusters AM mit dem in dem Verfahrensschritt 205 gemessenen Ansteuerungsmuster AM'. Hierbei ist es vorteilhaft, dass das bereitgestellte Ansteuerungsmuster AM und das gemessene Ansteuerungsmuster AM' in dem gleichen Datenformat abgespeichert werden. Zum Beispiel können das bereitgestellte Ansteuerungsmuster AM und das gemessene Ansteuerungsmuster AM' als jeweils in einer gespeicherten Tabelle vorliegen und werden in dem Verfahrensschritt 206 miteinander verglichen. Der Vergleich kann hierbei zellenweise, spaltenweise und/oder zeilenweise ausgeführt werden. Ferner ist es möglich, dass das bereitgestellte Ansteuerungsmuster AM und das gemessene Ansteuerungsmuster AM' in Form von Binärcodes vorliegen. Hierbei kann ein Vergleichen der jeweiligen Binärcodes in dem Verfahrensschritt 206 durchgeführt werden. Es gibt eine Vielzahl von Vergleichsmöglichkeiten für Binärcodes, zum Beispiel Algorithmen zur Messung einer Distanz von Zeichenketten. Insbesondere können in dem Verfahrensschritt 206 auch Vorgehensweisen der Mustererkennung angewendet werden.

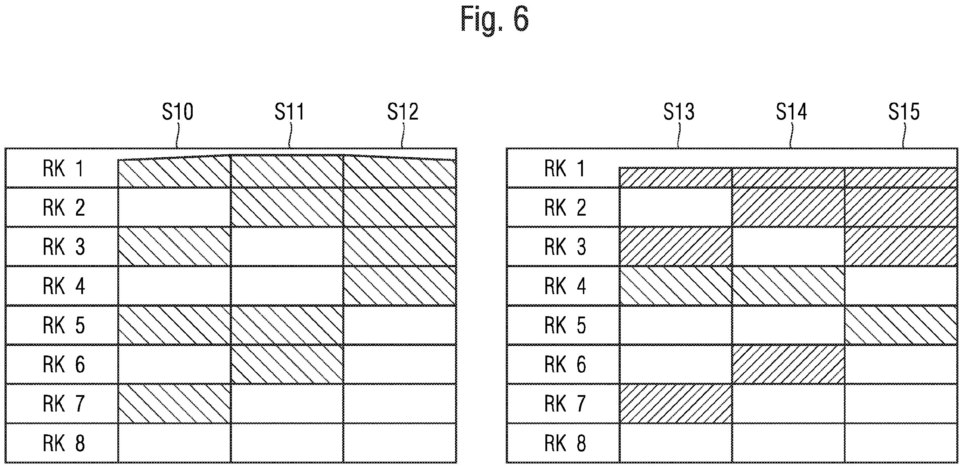

In dem Verfahrensschritt 206 erfolgt eine Identifikation von Unterschieden in dem bereitgestellten Ansteuerungsmuster AM und dem gemessenen Ansteuerungsmuster AM'. Somit ist es in dem Verfahrensschritt 207 möglich, eine bestehende tatsächliche Zuordnung von Regelkreisen RK zu Regelvorrichtungen RV zu identifizieren. Ein Identifizieren der Zuordnung von Regelkreisen RK zu zumindest einer Regelvorrichtung RV ist gemäß einer bevorzugten Ausführungsform in Figur 6 schematisch dargestellt.

In einem weiteren, optionalen Verfahrensschritt 208 kann ein Korrigieren einer fehlerhaften Zuordnung von Regelkreisen RK zu mindestens einer Regelvorrichtung RV durchgeführt werden. Hierbei ist es möglich, bei zukünftigen Ansteuerungen der Regelkreise RK lediglich ein Ansteuern von Schnittstellen zu vertauschen. Wurde beispielsweise eine Verkabelung eines ersten Regelkreises RK1 mit der Verkabelung eines zweiten Regelkreises RK2 vertauscht, so kann für zukünftige Ansteuerungen des ersten Regelkreises RK1 die Schnittstelle des zweiten Regelkreises RK2 angesprochen werden, ohne jedoch die physische Verkabelung zu korrigieren. Auf diese Weise ist eine effiziente Fehlerbehebung bezüglich der Verkabelung möglich.

Die vorbeschriebenen Verfahrensschritte können iterativ und/oder in anderer Reihenfolge ausgeführt werden und können weitere Unterschritte umfassen.

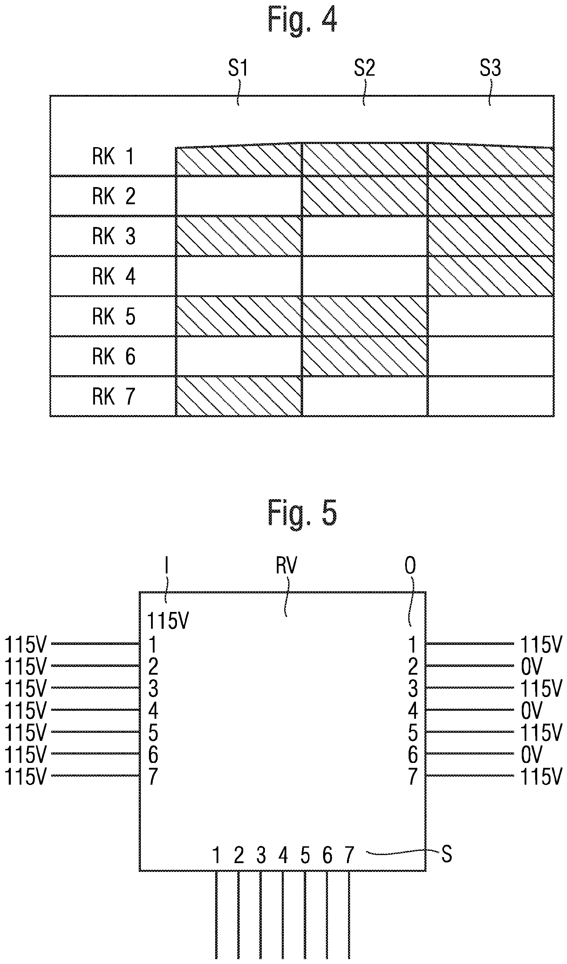

Figur 4 zeigt eine schematische Darstellung eines Ansteuerungsmusters AM gemäß einer Ausführungsform der vorliegenden Erfindung. Mit dem in der vorliegenden Figur 4 gezeigten Ansteuerungsmusters AM können acht Regelkreise RK, welche in der linken Spalte angetragen sind, angesteuert werden. Die weiteren Spalten S1, S2 und S3 zeigen Ansteuerungsphasen, welche in ihrer Gesamtheit das Ansteuerungsmuster AM bilden darstellen. In einer ersten Ansteuerungsphase der Regelkreise RK1-RK7, nämlich der Ansteuerungsphase S1 wird die Auswahl erster, dritter, fünfter und siebter Regelkreise RK angesprochen. Dies ist in der vorliegenden Tabelle als ausgefüllte Zellen gekennzeichnet. In einer zweiten Ausführungsphase gemäß S2 werden lediglich die Regelkreise RK1, RK2, RK5 und RK6 angesteuert. Somit ergibt sich ein eindeutiges Ansteuerungsmuster AM für jeden der Regelkreise RK1-RK7. Jeder der Regelkreise RK ist in der vorliegenden Tabelle mittels genau einer Zeile eindeutig identifizierbar und somit eindeutig anzusteuern.

In dem vorliegenden Ausführungsbeispiel erfolgt ein Ansteuern der Regelkreise RK binär. Das heißt, Regelkreise RK werden entweder angesteuert bzw. aktiviert oder werden nicht angesteuert bzw. deaktiviert. Somit ergibt sich ein eindeutiges Ansteuern der Regelkreise RK gemäß einem zeilenweise eindeutigen Binärcode. Es kann beispielsweise der Binärcode, mittels dessen der siebte Regelkreis RK7 angesteuert wird, als 100 bezeichnet werden. Der Binärcode, mit dem der Regelkreis RK5 angesprochen wird, kann zum Beispiel als Binärcodewort 110 bezeichnet werden. Es ist somit möglich, jedem einzelnen Regelkreis RK1-RK7 einen Binärcode bzw. ein Binärcodewort zuzuweisen, wobei die Gesamtheit der Binärcodes das Ansteuerungsmuster AM bildet. Folglich ist in der in der vorliegenden Figur 4 gezeigten Tabelle spaltenweise jeweils eine Ansteuerungsphase und zeilenweise jeweils ein Binärcode zu entnehmen.

Zum Vergleichen eines bereitgestellten Ansteuerungsmusters AM und eines gemessenen Ansteuerungsmusters AM' kann eine erste Tabelle gemäß dem bereitgestellten Ansteuerungsmuster AM mit einer zweiten Tabelle gemäß dem gemessenen Ansteuerungsmuster AM' übereinander gelegt werden und somit Abweichungen bzw. Differenzen in den beiden Ansteuerungsmustern identifiziert werden. Hierbei gibt jede detektierte Abweichung einen Hinweis auf einen vertauschten Regelkreis RK.

Figur 5 zeigt eine schematische Darstellung einer Regelvorrichtung RV, welche zum Empfangen von Eingangssignalen I sowie zum Erzeugen vom Ausgangssignalen O geeignet ist. Ferner umfasst die Regelvorrichtung RV in dem vorliegenden Ausführungsbeispiel Sensoreingänge S. Mittels der Regelvorrichtung RV kann eine Mehrzahl, in dem vorliegenden Ausführungsbeispiel eine Anzahl von acht Regelkreisen RK angesprochen werden. Hierbei wird in dem vorliegenden Ausführungsbeispiel ein Eingangssignal I mit einer Spannung von 115 V angelegt und als Ausgangssignal eine Spannungsverteilung gemäß dem bereitgestellten Ansteuerungsmuster AM geliefert. Bei dem in der vorliegenden Figur 5 gezeigten bereitgestellten Ansteuerungsmuster AM kann es sich zum Beispiel um die erste Ansteuerungsphase, gemäß Figur 4 handeln.

Bei der in Figur 5 gezeigten Regelvorrichtung RV kann es sich zum Beispiel um eine IPCU, auch Ice Protection Control Unit genannt, handeln. Eine derartige IPCU findet in Flugzeugen zur Ansteuerung von Heizelementen, insbesondere zur Vermeidung eines Vereisens von Rohrleitungen, Einsatz.

Figur 6 zeigt zwei Ansteuerungsmuster AM, nämlich ein bereitgestelltes Ansteuerungsmuster AM und ein gemessenes Ansteuerungsmuster AM' gemäß einer Ausführungsform der vorliegenden Erfindung.

Bei dem bereitgestellten Ansteuerungsmuster AM gemäß der Spalten S10-S12 kann es sich um das in Figur 4 gezeigte Ansteuerungsmuster AM handeln. Dieses Ansteuerungsmuster AM gemäß der Spalten S10-S12 kann auch als erwartetes Ansteuerungsmuster bezeichnet werden. Jeder der Regelkreise RK ist in der vorliegenden Tabelle mittels genau einer Zeile der Tabelle eindeutig identifizierbar und somit eindeutig anzusteuern.

In den Spalten S13-S15 ist ein gemessenes Ansteuerungsmuster AM' dargestellt. Hierbei ist die Aufteilung der Spalten und Zeilen analog zu dem bereitgestellten Ansteuerungsmuster AM gemäß der Spalten S10-S12 vorgenommen. Somit liegen die beiden Ansteuerungsmuster, nämlich das bereitgestellte Ansteuerungsmuster AM und das gemessene Ansteuerungsmuster AM', in dem gleichen Datenformat vor. Dies ist insbesondere deshalb vorteilhaft, da ein Identifizieren von Abweichungen in dem bereitgestellten Ansteuerungsmuster AM und in dem gemessenen Ansteuerungsmuster AM' mittels zeilenweisen Vergleichens durchgeführt werden kann.

In dem in Figur 6 gezeigten Beispiel ist die Verkabelung, das heißt die Zuordnung, des vierten Regelkreises RK4 mit der Verkabelung des fünften Regelkreises RK5 vertauscht. Mittels eines zeilenweisen Vergleichens der Ansteuerungsmuster gemäß der Regelkreise RK4 und RK5 wird identifiziert, dass eine Abweichung zwischen dem erwarteten Ansteuerungsmuster und dem tatsächlichen Ansteuerungsmuster vorliegt. Ferner kann in der vorliegenden Tabelle identifiziert werden, dass ein Vertauschen der Binärcodes des vierten Regelkreises RK4 mit den Binärcodes des fünften Regelkreises RK5 gemäß der Spalten S13, S14, und S15 die fehlerhafte Ansteuerung behebt. Somit ist es möglich, bei weiteren Ansteuerungen den Regelkreis RK4 mittels der Schnittstelle des Regelkreises RK5 anzusprechen und Regelkreis mittels der Schnittstelle des Regelkreises RK4 anzusprechen.

Folglich wurde die tatsächliche Zuordnung von Regelkreisen RK zu einer Regelvorrichtung RV durchgeführt.

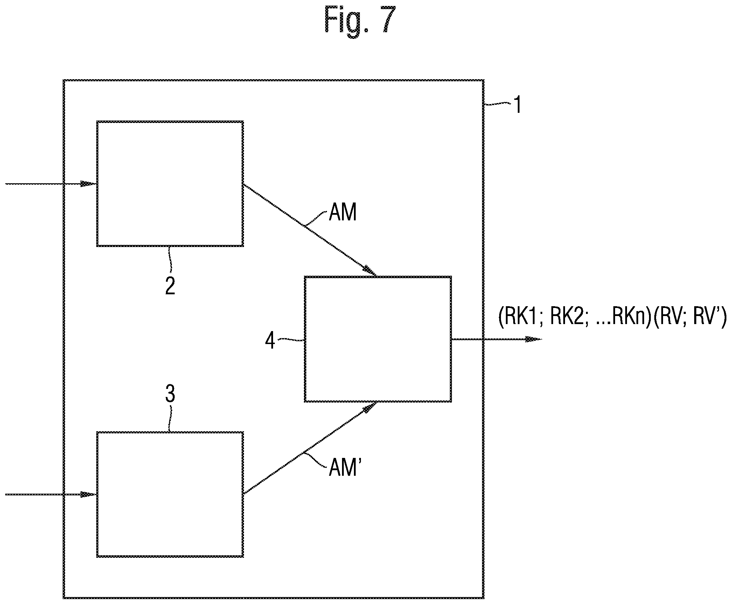

Figur 7 zeigt ein Blockdiagramm einer Vorrichtung 1 zur Identifikation einer Zuordnung von Regelkreisen der RK1; RK2; ...; RKn zu mindestens einer Regelvorrichtung RV.

Diese Vorrichtung weist eine Bereitstellungseinrichtung 2 zur Bereitstellung eines Ansteuerungsmusters AM auf, welches zum eindeutigen Ansteuern jedes einzelnen Regelkreises RK1; RK2;...; RKn durch die Regelvorrichtung RV geeignet ist.

Ferner ist eine Messvorrichtung 3 zur Messung eines weiteren Ansteuerungsmusters AM' bei einem Ansteuern der Regelkreise RK1; RK2;...; RKn gemäß dem bereitgestellten Ansteuerungsmuster AM vorgesehen.

Die Vorrichtung 1 enthält ferner eine Identifikationsvorrichtung 4 zur Identifikation der Zuordnung der Regelkreise RK1; RK2;...; RKn zu der mindestens einen Regelvorrichtung RV durch Vergleich des bereitgestellten Ansteuerungsmusters AM und des gemessenen Ansteuerungsmusters AM'.

Die Bereitstellungsvorrichtung 2 kann einen Eingang aufweisen, welcher geeignet ist, ein Ansteuerungsmuster AM aus einem Datenspeicher auszulesen beziehungsweise über die Schnittstelle zu empfangen. Die Messvorrichtung 3 kann einen Eingang aufweisen, welcher mit einem Messfühler, welcher in einem Regelkreis RK1; RK2;...; RKn vorgesehen ist, kommuniziert. Die Identifikationsvorrichtung 4 kann eine Zuordnung von Regelkreis RK1; RK2;...; RKn zu mindestens einer Regelvorrichtung RV, RV' ausgeben.

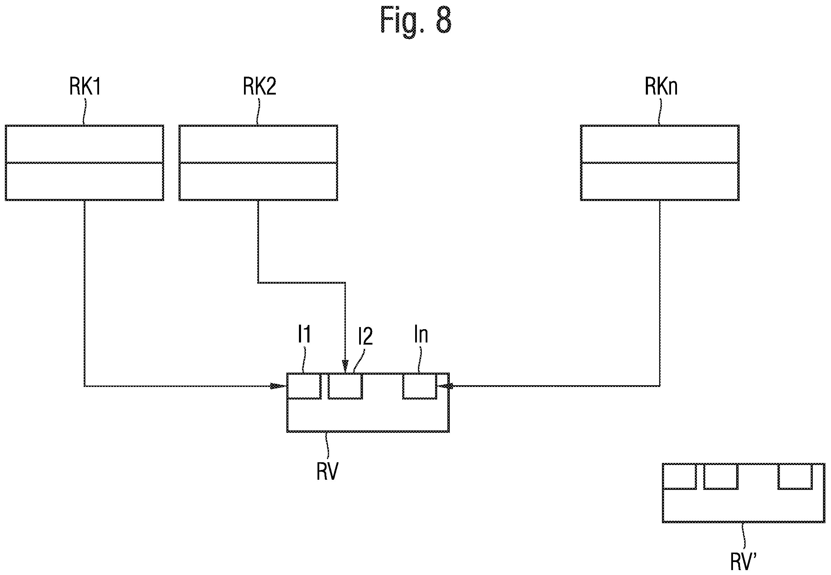

Figur 8 zeigt eine schematische Darstellung einer Zuordnung von Regelkreisen RK1; RK2;...; RKn zu mindestens einer Regelvorrichtung RV, RV'. In dem vorliegenden Ausführungsbeispiel umfasst jeder der Regelkreise RK1; RK2;...; RKn mindestens einen Aktuator und einen Sensor. Dies ist in der vorliegenden Figur 8 mittels einer Zweiteilung der jeweiligen Regelkreise RK1; RK2;...; RKn gekennzeichnet. Die jeweiligen Regelkreise RK1; RK2;...; RKn sind jeweils mit einer Schnittstelle I1; I2; ...; In mit der Regelvorrichtung RV verbunden. Hierbei ist es möglich, dass die Regelvorrichtung RV die einzelnen Aktuatoren mittels eines Ansteuerungsmusters AM ansteuert. Das bereitgestellte Ansteuerungsmuster AM kann zum Beispiel mittels der in Figur 7 gezeigten Bereitstellungsvorrichtung 2 an die Regelvorrichtung RV übermittelt werden. Ferner ist es möglich, dass der Eingang der in der Figur 7 gezeigten Messvorrichtung 3 mit jeweils einem Sensor der Regelkreise RK1; RK2;...; RKn verbunden ist. In der vorliegenden Ausführungsform ist eine weitere Regelvorrichtung RV' vorgesehen, an die weitere Regelkreise angeschlossen sein können.

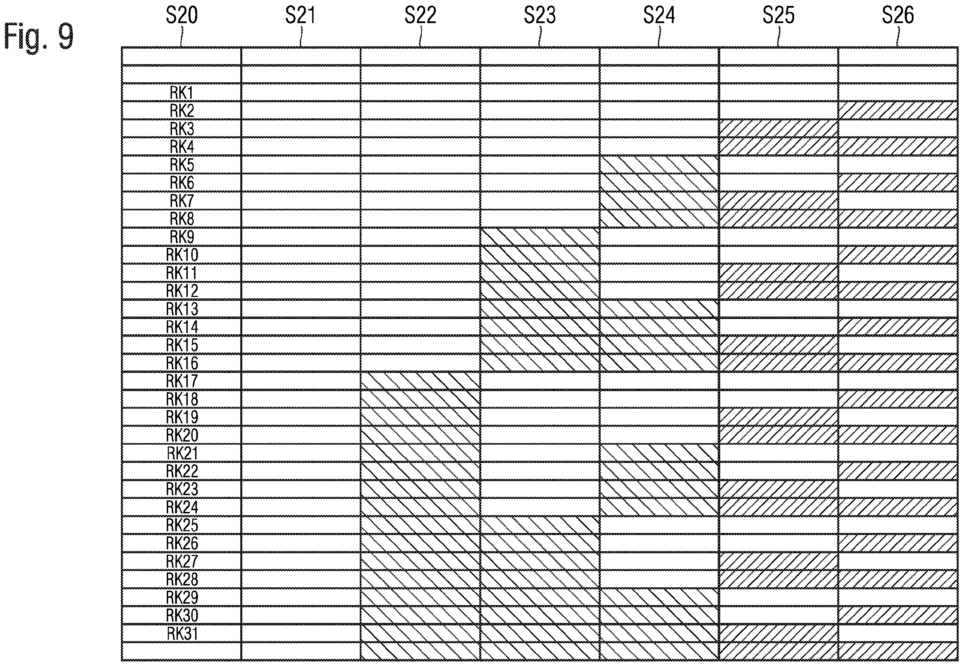

Die in der vorliegenden Figur 8 gezeigte Zuordnung von Regelkreisen RK1; RK2;...; RKn zu der mindestens einen Regelvorrichtung RV kann zum Beispiel mittels eines Ansteuerungsmusters AM gemäß Figur 9 identifiziert werden.

Figur 9 zeigt eine schematische Darstellung eines bereitgestellten Ansteuerungsmusters AM, wobei das bereitgestellte Ansteuerungsmuster AM mittels der Spalten S20, S21, S22, S23, S24, S25 und S26 dargestellt wird. Jeder der Regelkreise RK ist in der vorliegenden Tabelle mittels genau einer Zeile Rk1-Rk32 eindeutig identifizierbar und somit eindeutig anzusteuern.

Im vorliegenden Ausführungsbeispiel handelt es sich bei dem Ansteuerungsmuster AM um ein Heizmuster, welches mittels eines Heizercontrollers auf Heizelementanschlüsse aufgeschaltet wird. Der Heizercontroller kann zum Beispiel in der Regelvorrichtung RV vorgesehen sein, wobei ein Regelkreis RK als ein Heizkreis vorliegen kann. Durch die Aufschaltung vordefinierter Heizmuster werden die Heizperioden bei einem Identifizieren einer Zuordnung von Heizkreisen bei mindestens einem Heizercontroller minimiert. Ein typischer Heizercontroller, auch IPCU Ice Protection Control Unit genannt, hat 32 Heizeranschlüsse. Für den Einsatz vordefinierter Aufschaltmuster wird die Anzahl der Heizperioden von 32 auf 6 pro Controller reduziert. Bei 4-6 eingesetzten Controllern pro Flugzeug lässt sich die Anzahl der Heizzyklen folglich minimieren. Zum Beispiel hat ein bestimmtes Flugzeug sechs IPCU's in einem Heizsystem mit je 32 Heizkreisen, wobei sich bei einem manuellen Testen der einzelnen Heizer 6 x 32 = 192 Testzyklen ergeben. Mit einer Aufschaltung von vordefinierten Testmustern lässt sich das System mit 8 Heizzyklen testen. Dies entspricht einer Einsparung von 192 - 8 = 184 Zyklen mit 184 Zyklen x 5 min = 920 min. Hierbei dauert ein Heizzyklus typischerweise 5 Minuten.

## Patentansprüche

1. Verfahren zum Identifizieren einer Zuordnung von Regelkreisen (RK1; RK2; ...; RKn), welche jeweils einen Aktuator und einen Sensor aufweisen, zu mindestens einer Regelvorrichtung (RV; RV'), mit den Schritten:
Bereitstellen (100) eines Ansteuerungsmusters (AM), welches zum Ansteuern jedes einzelnen Regelkreises (RK1; RK2; ...; RKn) durch die Regelvorrichtung (RV; RV') geeignet ist, wobei das bereitgestellte Ansteuerungsmuster (AM) Ansteuerungsphasen aufweist, die eine Auswahl an anzusteuernden Regelkreisen beschreiben und in bestimmten Reihenfolgen abgearbeitet werden;
Ansteuern der Aktuatoren der Regelkreise (RK1; RK2; ...; RKn) durch die Regelvorrichtung (RV; RV') gemäß der Ansteuerungsphasen;
Auslesen der Sensoren der angesteuerten Regelkreise (RK1; RK2; ...; RKn) gemäß der Ansteuerungsphasen;
Wiederholen der Schritte des Ansteuerns und Auslesens für jede der Ansteuerungsphasen zum Messen (101) von Zustandsänderungen der angesteuerten Regelkreise, wobei die gemessenen Zustandsänderungen zu einem gemessenen Ansteuerungsmuster (AM') zusammengefügt werden, das einen Hinweis darauf gibt, welche Regelkreise bei der Ansteuerung gemäß dem bereitgestellten Ansteuerungsmuster (AM) tatsächlich angesteuert worden sind; und
Identifizieren (102) der Zuordnung jedes der Regelkreise (RK1; RK2; ...; RKn) zu der mindestens einen Regelvorrichtung (RV; RV') mittels eines Vergleichens des bereitgestellten Ansteuerungsmusters (AM) und des gemessenen Ansteuerungsmusters (AM').

2. Verfahren nach Anspruch 1, wobei das bereitgestellte Ansteuerungsmuster (AM) und/oder das gemessene Ansteuerungsmuster (AM') mittels mindestens eines Binärcodes dargestellt werden.

3. Verfahren nach Anspruch 2, wobei die Anzahl der Stellen mindestens eines Binärcodes gleich der Anzahl der Ansteuerungsphasen ist.

4. Verfahren nach Anspruch 3, wobei die Anzahl der Binärcodes, welche das bereitgestellte Ansteuerungsmuster (AM) und/oder das gemessene Ansteuerungsmuster (AM') darstellen, gleich der Anzahl der Regelkreise (RK1; RK2; ...; RKn) ist.

5. Verfahren nach einem der Ansprüche 1 bis 4, wobei das bereitgestellte Ansteuerungsmuster (AM) und/oder das gemessene Ansteuerungsmuster (AM') als mindestens eine gespeicherte Tabelle vorliegen.

6. Verfahren nach Anspruch 5, wobei Spalten der gespeicherten Tabelle die Ansteuerungsphasen angeben und Zeilen der gespeicherten Tabelle die Binärcodes angeben.

7. Vorrichtung (1) zur Identifikation einer Zuordnung von Regelkreisen (RK1; RK2; ...; RKn), welche jeweils einen Aktuator und einen Sensor aufweisen, zu mindestens einer Regelvorrichtung (RV; RV'), mit:
einer Bereitstellungsvorrichtung (2) zur Bereitstellung eines Ansteuerungsmusters (AM), welches zum Ansteuern jedes einzelnen Regelkreises (RK1; RK2; ...; RKn) durch die Regelvorrichtung (RV; RV') vorgesehen ist, wobei das bereitgestellte Ansteuerungsmuster (AM) Ansteuerungsphasen aufweist, die eine Auswahl an anzusteuernden Regelkreisen beschreiben und in bestimmten Reihenfolgen abgearbeitet werden;
einer Messvorrichtung (3) zur Messung von, bei einem Wiederholen des Ansteuerns der Aktuatoren der Regelkreise (RK1; RK2; ...; RKn) durch die Regelvorrichtung (RV; RV') gemäß der Ansteuerungsphasen und Auslesens der Sensoren der angesteuerten Regelkreise (RK1; RK2; ...; RKn) gemäß der Ansteuerungsphasen, Zustandsänderungen der angesteuerten Regelkreise, wobei die gemessenen Zustandsänderungen zu einem gemessenen Ansteuerungsmuster (AM') zusammengefügt werden, das einen Hinweis darauf gibt, welche Regelkreise bei der Ansteuerung gemäß dem bereitgestellten Ansteuerungsmuster (AM) tatsächlich angesteuert worden sind; und
einer Identifikationsvorrichtung (4) zur Identifikation der Zuordnung jedes der Regelkreise (RK1; RK2; ...; RKn) zu der mindestens einen Regelvorrichtung (RV; RV') mittels eines Vergleichens des bereitgestellten Ansteuerungsmusters (AM) und des gemessenen Ansteuerungsmusters (AM').

8. Vorrichtung (1) nach Anspruch 7, wobei die Regelvorrichtung (RV; RV') durch mindestens eine Steuervorrichtung, eine Kontrollvorrichtung, eine Messvorrichtung und/oder eine Auswertevorrichtung gebildet wird.

9. Vorrichtung (1) nach einem der Ansprüche 7 bis 8, wobei die Regelkreise (RK1; RK2; ...; RKn) Heizkreise sind und wobei die Aktuatoren Heizelemente sind.

10. Computerprogrammprodukt mit Programmbefehlen zur Durchführung des Verfahrens gemäß einem der Ansprüche 1 bis 6.

11. Datenspeicher, der das Computerprogrammprodukt nach Anspruch 10 speichert.

## Claims

1. Method for identifying an assignment of control loops (RK1; RK2; ...; RKn), which each have an actuator and a sensor, to at least one control apparatus (RV; RV'), having the steps of:
providing (100) an actuation pattern (AM) which is suitable for actuating each individual control loop (RK1; RK2; ...; RKn) by means of the control apparatus (RV; RV'), wherein the provided actuation pattern (AM) has actuation phases which describe a selection of control loops to be actuated and are executed in particular orders;
actuating the actuators in the control loops (RK1; RK2; ...; RKn) by means of the control apparatus (RV; RV') according to the actuation phases;
reading the sensors in the actuated control loops (RK1; RK2; ...; RKn) according to the actuation phases;
repeating the steps of actuation and reading for each of the actuation phases in order to measure (101) state changes of the actuated control loops, wherein the measured state changes are combined to form a measured actuation pattern (AM') which indicates which control loops have actually been actuated during actuation according to the provided actuation pattern (AM); and
identifying (102) the assignment of each of the control loops (RK1; RK2; ...; RKn) to the at least one control apparatus (RV; RV') by comparing the provided actuation pattern (AM) and the measured actuation pattern (AM').

2. Method according to Claim 1, wherein the provided actuation pattern (AM) and/or the measured actuation pattern (AM') is/are represented by means of at least one binary code.

3. Method according to Claim 2, wherein the number of digits in at least one binary code is equal to the number of actuation phases.

4. Method according to Claim 3, wherein the number of binary codes representing the provided actuation pattern (AM) and/or the measured actuation pattern (AM') is equal to the number of control loops (RK1; RK2; ...; RKn).

5. Method according to one of Claims 1 to 4, wherein the provided actuation pattern (AM) and/or the measured actuation pattern (AM') is/are present as at least one stored table.

6. Method according to Claim 5, wherein columns in the stored table indicate the actuation phases and rows in the stored table indicate the binary codes.

7. Apparatus (1) for identifying an assignment of control loops (RK1; RK2; ...; RKn), which each have an actuator and a sensor, to at least one control apparatus (RV; RV'), having:
a provision apparatus (2) for providing an actuation pattern (AM) which is provided for the purpose of actuating each individual control loop (RK1; RK2; ...; RKn) by means of the control apparatus (RV; RV'), wherein the provided actuation pattern (AM) has actuation phases which describe a selection of control loops to be actuated and are executed in particular orders;
a measuring apparatus (3) for measuring state changes of the actuated control loops when the actuation of the actuators in the control loops (RK1; RK2; ...; RKn) is repeated by the control apparatus (RV; RV') according to the actuation phases and the sensors in the actuated control loops (RK1; RK2; ...; RKn) are read according to the actuation phases, wherein the measured state changes are combined to form a measured actuation pattern (AM') which indicates which control loops have actually been actuated during actuation according to the provided actuation pattern (AM); and
an identification apparatus (4) for identifying the assignment of each of the control loops (RK1; RK2; ...; RKn) to the at least one control apparatus (RV; RV') by comparing the provided actuation pattern (AM) and the measured actuation pattern (AM').

8. Apparatus (1) according to Claim 7, wherein the control apparatus (RV; RV') is formed by at least a regulating apparatus, a monitoring apparatus, a measuring apparatus and/or an evaluation apparatus.

9. Apparatus (1) according to one of Claims 7 to 8, wherein the control loops (RK1; RK2; ...; RKn) are heating circuits, and wherein the actuators are heating elements.

10. Computer program product having program instructions for carrying out the method according to one of Claims 1 to 6.

11. Data memory which stores the computer program product according to Claim 10.

## Revendications

1. Procédé pour identifier une association de circuits de régulation (RK1 ; RK2 ; ... ; RKn), lesquels possèdent respectivement un actionneur et un capteur, à au moins un dispositif de régulation (RV ; RV'), comprenant les étapes suivantes :
fourniture (100) d'un modèle de pilotage (AM) qui est conçu pour le pilotage de chaque circuit de régulation (RK1 ; RK2 ; ... ; RKn) individuel par le dispositif de régulation (RV ; RV'), le modèle de pilotage (AM) fourni possédant des phases de pilotage qui décrivent une sélection de circuits de régulation à piloter et qui sont exécutées dans des séquences définies ;
pilotage des actionneurs des circuits de régulation (RK1 ; RK2 ; ... ; RKn) par le dispositif de régulation (RV ; RV') conformément aux phases de pilotage ;
lecture des capteurs des circuits de régulation (RK1 ; RK2 ; ... ; RKn) pilotés conformément aux phases de pilotage ;
répétition des étapes de pilotage et de lecture pour chacune des phases de pilotage en vue de mesurer (101) des changements d'état des circuits de régulation pilotés, les changements d'état mesurés étant fusionnés en un modèle de pilotage mesuré (AM') qui donne une indication à propos des circuits de régulation qui ont réellement été pilotés lors du pilotage conformément au modèle de pilotage (AM) fourni ; et
identification (102) de l'association de chacun des circuits de régulation (RK1 ; RK2 ; ... ; RKn) à l'au moins un dispositif de régulation (RV ; RV') au moyen d'une comparaison du modèle de pilotage (AM) fourni et du modèle de pilotage mesuré (AM').

2. Procédé selon la revendication 1, le modèle de pilotage (AM) fourni et/ou le modèle de pilotage mesuré (AM') étant représentés au moyen d'au moins un code binaire.

3. Procédé selon la revendication 2, le nombre de caractères d'au moins un code binaire étant égal au nombre de phases de pilotage.

4. Procédé selon la revendication 3, le nombre de codes binaires qui représentent le modèle de pilotage (AM) fourni et/ou le modèle de pilotage mesuré (AM') étant égal au nombre de circuits de régulation (RK1 ; RK2 ; ... ; RKn).

5. Procédé selon l'une des revendications 1 à 4, le modèle de pilotage (AM) fourni et/ou le modèle de pilotage mesuré (AM') se présentant sous la forme d'au moins un tableau mémorisé.

6. Procédé selon la revendication 5, les colonnes du tableau mémorisé indiquant les phases de pilotage et les lignes du tableau mémorisé indiquant les codes binaires.

7. Dispositif (1) pour identifier une association de circuits de régulation (RK1 ; RK2 ; ... ; RKn), lesquels possèdent respectivement un actionneur et un capteur, à au moins un dispositif de régulation (RV ; RV'), comprenant :
un dispositif de fourniture (2) destiné à fournir un modèle de pilotage (AM) qui est conçu pour le pilotage de chaque circuit de régulation (RK1 ; RK2 ; ... ; RKn) individuel par le dispositif de régulation (RV ; RV'), le modèle de pilotage (AM) fourni possédant des phases de pilotage qui décrivent une sélection de circuits de régulation à piloter et qui sont exécutées dans des séquences définies ;
un dispositif de mesure (3) destiné à mesurer des changements d'état des circuits de régulation pilotés lors d'un pilotage répété des actionneurs des circuits de régulation (RK1 ; RK2 ; ... ; RKn) par le dispositif de régulation (RV ; RV') conformément aux phases de pilotage et d'une lecture des capteurs des circuits de régulation (RK1 ; RK2 ; ... ; RKn) pilotés conformément aux phases de pilotage, les changements d'état mesurés étant fusionnés en un modèle de pilotage mesuré (AM') qui donne une indication à propos des circuits de régulation qui ont réellement été pilotés lors du pilotage conformément au modèle de pilotage (AM) fourni ; et
un dispositif d'identification (4) destiné à identifier l'association de chacun des circuits de régulation (RK1 ; RK2 ; ... ; RKn) à l'au moins un dispositif de régulation (RV ; RV') au moyen d'une comparaison du modèle de pilotage (AM) fourni et du modèle de pilotage mesuré (AM').

8. Dispositif (1) selon la revendication 7, le dispositif de régulation (RV ; RV') étant formé par au moins un dispositif de commande, un dispositif de contrôle, un dispositif de mesure et/ou un dispositif d'interprétation.

9. Dispositif (1) selon l'une des revendications 7 à 8, les circuits de régulation (RK1 ; RK2 ; ... ; RKn) étant des circuits de chauffage et les actionneurs étant des éléments chauffants.

10. Produit de programme informatique comprenant des instructions de programme servant à mettre en oeuvre le procédé selon l'une des revendications 1 à 6.

11. Mémoire de données, laquelle enregistre le produit de programme informatique selon la revendication 10.
